# FASCICULE DE BREVET EUROPEEN

(11) **EP 3 718 379 B1**
(45) Date de publication et mention de la délivrance du brevet: **25.01.2023**
(21) Numéro de dépôt: 18800174.7
(22) Date de dépôt: 12.11.2018
(51) Int. Cl.: H05K 1/02, H02M 1/12, H02M 7/00, H02J 7/02

(54) **CIRCUIT ÉLECTRIQUE DE FILTRAGE, CHARGEUR DE COURANT COMPRENANT UN TEL CIRCUIT, ET VÉHICULE AUTOMOBILE ÉQUIPÉ D'UN TEL CHARGEUR DE COURANT**
FILTRIERUNGS ELEKTRONISCHER SCHALTKREIS, STROMLADEGERÄT UMFASSEND SOLCH EINEN SCHALTKREIS, UND KRAFTFAHRZEUG VERSEHEN MIT EINEM SOLCHEN STROMLADEGERÄT
FILTERING ELECTRONIC CIRCUIT, CURRENT CHARGER COMPRISING SUCH A CIRCUIT AND AUTOMOBILE VEHICLE EQUIPPED WITH SUCH A CURRENT CHARGER

(30) Priorité: 01.12.2017 FR 1761551
(43) Date de publication de la demande: 07.10.2020
(73) Titulaire: Renault s.a.s, 92100 Boulogne Billancourt (FR); Nissan Motor Co., Ltd., Yokohama-shi, Kanagawa 221-0023 (JP)
(72) Inventeur: SAKR, Nadim, 75014 Paris (FR); DIOUF, Fatou, 78000 Versailles (FR); GHEONJIAN, Anna, Tbilisi 0177 (GE)
(74) Mandataire: Renault Group
(86) Numéro de dépôt international: PCT/EP2018/080976
(87) Numéro de publication internationale: WO 2019/105727

(56) Documents cités:
- EP-A1- 2 811 572
- WO-A1-2014/105887
- US-A1- 2014 084 957
- US-A1- 2016 087 323
- US-A1- 2016 174 362
- "Designing for EMC", IEE colloquium "EMC for the small business" on 1st May 1997 at the IEE, Savoy Place, London , 3 mai 1997 (1997-05-03), XP002784985, Extrait de l'Internet: URL:http://alt.ife.tugraz.at/Elektronik/Wi nkler/Files/desfremc.htm [extrait le 2018-09-21]
- Henry Ott Consultants: "Slots in Ground Planes", , 16 juillet 2002 (2002-07-16), XP002784986, Extrait de l'Internet: URL:http://www.hottconsultants.com/techtip s/tips-slots.html [extrait le 2018-09-21]

## Description

La présente invention concerne de manière générale le domaine du filtrage de fréquences dans des courants électriques.

Elle concerne en particulier un circuit électrique de filtrage, destiné à équiper un chargeur de véhicule automobile électrique ou hybride, ce circuit électrique de filtrage étant alors destiné à être connecté entre :
- un réseau électrique externe au véhicule, susceptible d'alimenter en courant le véhicule, et
- un dispositif de conversion électrique équipant le chargeur.

Elle concerne plus précisément un circuit électrique de filtrage pour un chargeur de courant de véhicule automobile électrique ou hybride, comprenant une plaque de circuit imprimé qui supporte :
- une couche conductrice s'étendant sur la majeure partie de l'aire de la plaque, et reliant électriquement une première borne d'entrée du circuit à une première borne de sortie du circuit,
- au moins un composant électrique, et
- une piste électrique pour la connexion dudit composant électrique, qui s'étend dans un plan de connexion parallèle à celui de la couche conductrice, entre une deuxième borne d'entrée et une deuxième borne de sortie du circuit.

### ARRIERE-PLAN TECHNOLOGIQUE

Les véhicules automobiles à propulsion électrique ou hybride sont de plus en plus répandus. L'énergie électrique permettant de mettre en mouvement un tel véhicule est généralement fournie par une batterie électrique, dite de traction, qui peut être rechargée en connectant le véhicule à un réseau de distribution d'électricité.

Cette batterie électrique est alors reliée au réseau de distribution d'électricité par l'intermédiaire d'un chargeur qui comporte un dispositif de conversion d'énergie électrique.

Ce dispositif de conversion est configuré pour convertir la tension électrique alternative délivrée par le réseau en une tension électrique continue alimentant la batterie électrique de traction. Il comprend généralement un redresseur (convertisseur « AC/DC »), et un convertisseur de courant continu (convertisseur « DC/DC ») pour convertir la tension électrique continue produite par le redresseur en une autre tension électrique continue adaptée à la batterie électrique.

Le dispositif de conversion comprend généralement des interrupteurs commandés, tels que des thyristors. Les commutations de ces interrupteurs commandés génèrent en mode différentiel et en mode commun des composantes de courant électrique à hautes fréquences.

En l'absence de précautions particulières, ces composantes de courant électrique à hautes fréquences sont renvoyées par le chargeur dans le réseau de distribution électrique, et sont alors susceptibles de perturber le fonctionnement du chargeur lui-même ainsi que le fonctionnement d'autres appareils électriques reliés à ce réseau. Différentes normes limitent d'ailleurs les perturbations électromagnétiques qu'un tel véhicule est autorisé à émettre en direction du réseau de distribution électrique qui l'alimente.

Pour éviter d'injecter ces composantes de courant électrique à hautes fréquences dans le réseau de distribution électrique, le chargeur du véhicule est généralement muni d'un circuit électrique de filtrage, du type passe-bas, connecté entre le dispositif de conversion du chargeur et le réseau de distribution qui alimente le chargeur.

Il est connu en particulier de réaliser ce circuit électrique de filtrage au moyen d'une plaque de circuit imprimée tel que décrite ci-dessus (avec au moins deux couches, dont une couche conductrice appelée plan de masse et une couche dans laquelle s'étend une piste électrique), dans laquelle ladite piste, qui relie la deuxième borne de sortie à la deuxième borne d'entrée, est rectiligne.

Mais cette configuration impose une forme allongée au circuit électrique de filtrage, ce qui s'avère contraignant.

L'article « Designing for EMC » du collogue IEE « EMC for small business" du 1er mai 1997, explique au paragraphe "grounding and PCB layout", qu'il est préférable d'employer un plan de masse d'un seul tenant, sans fente, pour réduire les émissions électromagnétiques d'un circuit électrique. Lorsqu'une telle fente ne peut être évitée, il convient alors que la piste électrique, suivie par le courant électrique dans un plan de connexion, contourne la fente, pour éviter la formation d'une boucle de courant.

La page internet « Slots in Ground Planes » accessible à l'adresse http://www.hottconsultants.com/techtips/tips-slots.html, de Henry Ott Consultants, décrit un circuit électrique sommaire comprenant un plan de masse fendu, et, sur une autre face, une piste électrique. Cette page conseille d'éviter de telles fentes qui provoquent des boucles de courant.

Le document US2016087323 décrit un dispositif pour filtrer le bruit électromagnétique à très haute fréquence, dans la gamme des GHz. Ce dispositif comprend une piste électrique et un plan de masse dans lequel une fente est pratiquée, des impédances étant connectées entre deux bords de la fente.

### OBJET DE L'INVENTION

Afin de remédier à l'inconvénient précité de l'état de la technique, la présente invention propose un circuit électrique de filtrage à la fois compact et autorisant une forte atténuation de composantes du courant électrique à hautes fréquences.

Plus particulièrement, on propose selon l'invention, telle que décrite par la revendication 1, un circuit électrique de filtrage tel que défini en introduction, dans lequel :
- ladite piste s'étend le long d'un chemin qui n'est pas rectiligne, et dans lequel
- une fente est pratiquée dans la couche conductrice, la fente étant située entre la première borne d'entrée et la première borne de sortie.

Le fait que ladite piste s'étende le long d'un chemin qui n'est pas rectiligne autorise une implantation compacte du ou des composants électriques du circuit.

La demanderesse a constaté toutefois que les performances du circuit en termes d'atténuation des composantes de courant à hautes fréquences seraient alors, en l'absence de ladite fente, inférieures à ce qui était obtenu avec une piste rectiligne sur toute sa longueur.

Une explication de cette dégradation est que, dans cette configuration (piste non rectiligne, absence de fente) :
- le chemin aller, suivi par le courant électrique (dit de « mode commun ») dans la piste électrique, et
- le chemin de retour, suivi par ce courant électrique dans le plan de masse formé par la couche conductrice,
forment ensemble une sorte de boucle de courant électrique.

En effet, on sait que le courant électrique suit toujours le chemin qui présente l'impédance la plus petite. En l'absence de la fente, le chemin de retour est donc un segment rectiligne reliant la première borne d'entrée à la première borne de sortie.

Quant au chemin aller, il s'agit au contraire du chemin, non rectiligne, suivi par ladite piste.

Ces deux chemins forment donc ensemble une sorte de boucle de courant.

Cette boucle de courant génère un champ magnétique, en l'occurrence variable puisqu'il s'agit de composantes du courant électrique à hautes fréquences. Ce champ magnétique variable génère donc par induction une tension et un courant électriques induits en sortie du circuit de filtrage, dégradant ainsi les performances du circuit.

Autrement formulé, la boucle de courant se couple, par induction, aux conducteurs électriques situés en sortie du filtre (donc du côté du réseau de distribution), si bien qu'une partie des composantes de courant à hautes fréquences transite de l'entrée du circuit de filtrage, vers sa sortie.

Grâce à l'invention, la fente pratiquée dans la couche conductrice modifie le chemin de retour suivi par le courant électrique. Grâce à cette fente, le chemin de retour du courant électrique peut donc être plus proche de son chemin aller, c'est à dire plus proche du chemin suivi par ladite piste.

Préférentiellement, la fente est située à l'aplomb d'une surface délimitée, dans le plan de connexion, par, d'une part, le chemin suivi par ladite piste, et, d'autre part, la droite reliant la deuxième borne d'entrée et la deuxième borne de sortie.

Comme la fente s'étend à l'aplomb de la surface délimitée par la piste, elle impose au courant électrique qui circule dans la couche conductrice de contourner la surface précitée.

La fente pratiquée dans la couche conductrice permet donc de réduire l'aire de la boucle de courant mentionnée ci-dessus, réduisant ainsi l'amplitude du champ magnétique parasite généré par la boucle.

Par ailleurs, la fente génère un rétrécissement local de largeur de la couche conductrice, ce qui augmente l'inductance propre présentée par cette couche entre ses bornes d'entrée et de sortie. La demanderesse a constaté que cette augmentation d'inductance contribue à atténuer les composantes de courant électrique à hautes fréquences transmises en sortie du circuit.

D'autres caractéristiques non limitatives et avantageuses du circuit électrique conforme à l'invention, prises individuellement ou selon toutes les combinaisons techniquement possibles, sont les suivantes :
- le chemin suivi par ladite piste a une forme de créneau comportant trois côtés adjacents ;
- la fente est située plus près de la deuxième borne de sortie que de la deuxième borne d'entrée ;
- la fente n'est pas superposée dans son ensemble au chemin suivi par la piste ;
- la fente ne se superpose en aucun point à ladite piste ;
- la fente débouche sur un bord de la couche conductrice ;
- la fente présente une extrémité située à une distance d'un bord de la couche conductrice qui est inférieure au quart de la dimension de cette couche selon l'axe de la fente ;
- la plaque de circuit imprimé comprend en outre une troisième borne d'entrée et une troisième borne de sortie reliées l'une à l'autre par le circuit, ainsi qu'une quatrième borne d'entrée et une quatrième borne de sortie également reliées l'une à l'autre par le circuit ;
- le module d'une fonction de transfert du circuit électrique, égale :
   - au courant électrique sortant du circuit par la première borne de sortie, divisé par
   - un courant électrique de mode commun, qui est égal à la somme des courants électriques entrant dans le circuit respectivement par la deuxième, la troisième et la quatrième bornes d'entrée,
est inférieur à 1 pour les fréquences supérieures à une fréquence seuil donnée.

L'invention propose également un chargeur de courant pour véhicule automobile électrique ou hybride, comprenant :
- au moins deux bornes de connexion à un réseau de distribution d'électricité externe,
- un dispositif de conversion d'énergie électrique, configuré pour convertir une tension électrique alternative en une tension électrique continue, et
- un circuit électrique de filtrage tel que décrit ci-dessus, le circuit étant raccordé :
   - au dispositif de conversion par ses première et deuxième bornes d'entrée, et
   - aux bornes de connexion du chargeur par ses première et deuxième bornes de sortie.

L'invention prévoit aussi un véhicule automobile électrique ou hybride comprenant le chargeur de courant qui vient d'être présenté.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 représente schématiquement un chargeur de courant de véhicule automobile électrique ou hybride, comprenant un circuit électrique de filtrage conforme à l'invention,
- la figure 2 représente plus en détail le circuit électrique de la figure 1, et
- la figure 3 représente plus particulièrement une couche conductrice du circuit électrique de la figure 2.

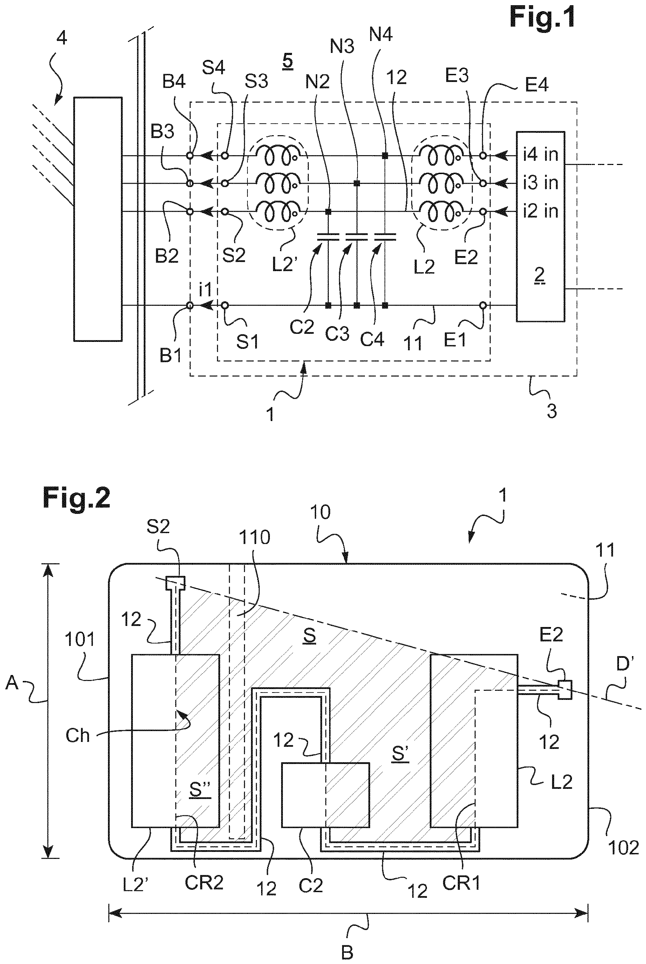

La figure 1 montre les principaux éléments d'un chargeur 3 de courant d'un véhicule automobile 5 électrique ou hybride (ce véhicule n'étant représenté que très partiellement).

Le chargeur 3 comprend ici quatre bornes de connexion B1 à B4, permettant de le connecter à un réseau 4 de distribution d'électricité triphasé. La première borne de connexion, B1, est destinée à être reliée à la terre, et les trois autres bornes de connexion, B2 à B4, sont destinées à être reliées respectivement au trois phases délivrées par ce réseau 4 de distribution.

Le chargeur 3 comprend aussi un circuit électrique 1 de filtrage comprenant quatre bornes de sortie S1 à S4 respectivement raccordées électriquement aux quatre bornes de connexion B1 à B4 du chargeur 3.

Ce circuit électrique 1, qui sera décrit en détail plus bas, comprend également quatre bornes d'entrée E1 à E4 raccordées électriquement à un dispositif de conversion 2 d'énergie électrique.

Le dispositif de conversion 2 qui équipe le chargeur 3 est configuré pour convertir les tensions électriques alternatives délivrées par le réseau de distribution 4 en une tension électrique continue appropriée pour recharger une batterie électrique de traction équipant le véhicule 5.

Le dispositif de conversion 2 comprend par exemple un redresseur et un convertisseur de courant continu pour convertir la tension électrique continue produite par le redresseur en une autre tension électrique continue adaptée à la batterie électrique.

Le circuit électrique 1 de filtrage peut maintenant être décrit plus en détail.

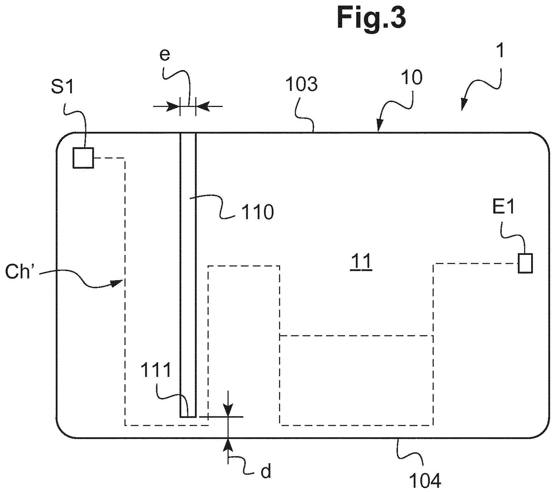

La première borne d'entrée du circuit, E1, est, de même que sa première borne de sortie S1, en contact avec la masse électrique du circuit (qui correspond à la terre du réseau 4 de distribution). Cette masse électrique est réalisée sous la forme d'une couche conductrice 11 (figures 2 et 3), ou plan de masse, qui sera décrite plus bas.

Les deuxième, troisième et quatrième bornes d'entrée E2, E3 et E4 sont reliées respectivement, par l'intermédiaire de composants électriques de filtrage, aux deuxième, troisième et quatrième bornes de sortie S2, S3 et S4.

Le circuit électrique 1 est configuré pour, entre son entrée (connectée au dispositif de conversion 2) et sa sortie (connectée au réseau de distribution 4), atténuer des composantes de courant électrique à hautes fréquences générées par le dispositif de conversion 2 du chargeur.

Plus précisément, le circuit électrique 1 de filtrage joue, vis-à-vis du courant électrique, le rôle d'un filtre passe-bas. Il laisse ainsi passer sans les atténuer les composantes de courant électrique à basses fréquences, en particulier à 50 et 60 Hertz, tandis qu'il atténue les composantes de courant électrique à hautes fréquences.

Le circuit électrique de filtrage permet ainsi d'éviter que des composantes de courant électrique à hautes fréquences, parasites, générées par le dispositif de conversion 2 du chargeur, ne soient injectées par le chargeur dans le réseau de distribution 4.

Le circuit électrique de filtrage a cet effet de filtre passe-bas vis-à-vis du courant électrique dit de mode commun, c'est-à-dire ici vis-à-vis de la somme des trois courants électriques i2ᵢₙ, i3ᵢₙ et i4ᵢₙ associés respectivement aux trois phases de courant électrique triphasé notée icmᵢₙ= i2ᵢₙ + i3ᵢₙ + i4ᵢₙ.

Pour réaliser cette fonction de filtre passe-bas en mode commun, les trois courants électriques i2ᵢₙ, i3ᵢₙ et i4ᵢₙ, qui entrent dans le circuit électrique 1 respectivement par la deuxième, la troisième et la quatrième borne d'entrée E2, E3, E4, subissent en mode commun un filtrage de type passe-bas.

Ainsi, le module d'une fonction de transfert du circuit électrique, égale au courant électrique i1 sortant (algébriquement) de la première borne de sortie S1 du circuit, divisé par le courant électrique de mode commun icmᵢₙ, est inférieur à 1 pour les fréquences supérieures à une fréquence seuil donnée (cette fréquence seuil peut être déterminée en pratique en fonction de la fréquence de commutation des interrupteurs commandés du dispositif de conversion 2 d'énergie électrique ; cette fréquence seuil peut être égale par exemple à la fréquence de commutation multipliée par un nombre entier ; la fréquence seuil est généralement supérieure à 10 kilohertz).

Ce filtrage du courant électrique de mode commun icmᵢₙ est réalisé ici au moyen d'un filtre en T (triple), comprenant :
- une première et d'une deuxième inductances L2 et L2' dites « de mode commun », et
- un premier, deuxième et troisième condensateurs C2, C3 et C4.

Chacune des première et deuxième inductances L2, L2' comprend trois bobinages (un par phase) couplés entre eux magnétiquement, par exemple par un noyau magnétique (figure 1).

Les entrées des trois bobinages de la première inductance L2 sont reliées respectivement aux deuxième, troisième et quatrième bornes d'entrée E2, E3 et E4 du circuit. Les sorties de ces trois bobinages sont reliées respectivement à un premier, deuxième et troisième noeuds N2, N3 et N4 du filtre.

La masse électrique du circuit est reliée électriquement aux premier, deuxième et troisième noeuds N2, N3 et N4 par l'intermédiaire respectivement des premier, deuxième et troisième condensateurs C2, C3 et C4.

Les entrées des trois bobinages de la deuxième inductance L2' sont reliées respectivement aux premier, deuxième et troisième noeuds N2, N3 et N4. Quant aux sorties de ces trois bobinages, elles sont reliées respectivement aux deuxième, troisième et quatrième bornes de sortie S2, S3 et S4 du circuit.

Le circuit électrique 1 de filtrage est réalisé au moyen d'une plaque 10 de circuit imprimé, représentée en partie sur les figures 2 et 3, sur laquelle sont soudés les composants électriques du circuit (notamment les premières et deuxièmes inductances L2 et L2', et les condensateurs).

Ici, cette plaque 10 est en forme de rectangle. Sa largeur A mesure environ 20 centimètres, et sa longueur B mesure environ 30 centimètres.

Dans le mode de réalisation décrit ici, la plaque de circuit imprimé est du type multi-couches, à 4 couches. Plus précisément, elle supporte :
- la couche conductrice 11 mentionnée plus haut, qui forme le plan de masse du circuit et qui s'étend sur la majeure partie de l'aire de la plaque,
- et trois plans de connexion (trois "couches"), chacun parallèle à celui de la couche conductrice 11.

Des pistes électriques, pour la connexion des composants électriques du circuit, s'étendent dans ces plans de connexion.

La figure 2 montre l'une de ces pistes électriques, qui s'étend entre la deuxième borne d'entrée E2 et la deuxième borne de sortie S2 du circuit. C'est le long de cette piste 12 que sont soudés les composants du filtre en T qui permet de filtrer le courant électrique i2ᵢₙ.

La deuxième borne d'entrée E2 et la deuxième borne de sortie S2, reliées par la piste 12, sont situées à l'opposée l'une de l'autre, dans le plan de connexion où s'étend la piste. La deuxième borne de sortie S2 est située à proximité d'un premier bord 101 du rectangle formé par la plaque 10 (plus précisément, à proximité d'un coin de la plaque), tandis que la deuxième borne d'entrée E2 est située à proximité d'un deuxième bord 102 de ce rectangle, opposé au premier bord 101.

Comme on peut le voir sur la figure 2 le chemin Ch suivi la piste 12, entre les deuxièmes bornes d'entrée et de sortie n'est pas rectiligne.

La piste 12 peut être interrompue sur certaines parties du chemin Ch qu'elle suit, pour laisser place aux composants électriques connectés à cette piste (première et deuxièmes inductances L2 et L2', capacité C2).

Ce chemin Ch correspond au trajet suivi, entre la deuxième borne d'entrée E2 et la deuxième borne de sortie S2, par une partie au moins du courant électrique i2ᵢₙ qui entre dans le circuit par la deuxième borne d'entrée E2.

Le fait que le chemin Ch ne soit pas rectiligne autorise une implantation compacte des composants électriques connectés à cette piste.

Ici, le chemin Ch forme, dans le plan de connexion dans lequel s'étend la piste, un premier créneau CR1 (comprenant 3 côtés), puis un deuxième créneau CR2 (comprenant également trois côtés) avant d'aboutir à la deuxième borne de sortie S2. Cela permet d'augmenter la longueur du chemin Ch le long duquel sont disposés les composants. En l'occurrence, la deuxième inductance L2' est située sur l'un des côtés du deuxième créneau CR2, tandis que la première inductance L2 et la capacité C2 occupent deux des côtés du premier créneau CR1.

Comme le chemin Ch n'est pas rectiligne, il s'écarte de la droite D' reliant la deuxième borne d'entrée E2 à la deuxième borne de sortie S2. Une surface S est donc délimitée, dans le plan de connexion, entre, d'une part, le chemin Ch suivi par ladite piste 12 et, d'autre part, la droite mentionnée ci-dessus (la surface S est représentée par des hachures, sur la figure 2).

Le premier créneau CR1 et le deuxième créneau CR2 formés par le chemin Ch délimitent d'ailleurs chacun une surface S', S" (encadrée par les trois côté du créneau considérée), en retrait par rapport à la droite D'.

Le chemin suivi entre la troisième borne d'entrée E3 et la troisième borne de sortie S3, par une partie au moins du courant électrique i3ᵢₙ qui entre dans le circuit par la troisième borne d'entrée, est proche du chemin Ch suivi par la piste 12.

De même, le chemin suivi entre la quatrième borne d'entrée E4 et la quatrième borne de sortie S4, par une partie au moins du courant électrique i4ᵢₙ qui entre dans le circuit par la quatrième borne d'entrée E4, est proche du chemin Ch suivi par la piste 12.

Ainsi, le chemin moyen suivi par le courant électrique de mode commun, qui entre dans le circuit par les deuxième, troisième et quatrième bornes d'entrée E2, E3 et E4, correspond au chemin Ch suivi par la piste 12.

La couche conductrice 11 est représentée plus en détail sur la figure 3 (la figure 2 représente à la fois la piste 12 et la couche conductrice 11, comme si la plaque 10 était transparente).

La couche conductrice 11 s'étend sur toute l'aire de la plaque 10, par exemple sur toute une face de cette plaque 10, à l'exception d'une fente 110 décrite ci-dessous.

Les premières bornes d'entrée E1 et de sortie S1 correspondent aux points de la couche conductrice 11 où sont soudés les conducteurs électriques qui raccordent cette couche aux éléments extérieurs au circuit (tels que la borne de connexion B1 du chargeur).

La fente 110 pratiquée dans la couche conductrice 11 est située entre la première borne d'entrée E1 et la première borne de sortie S1. Cette fente correspond à une zone dépourvue de matière conductrice, que ne peut donc traverser le courant électrique circulant dans la couche conductrice 11.

La fente est située ici à l'aplomb de la surface S mentionnée plus haut (on rappelle que cette surface S est délimitée par le chemin Ch suivi par la piste 12). Elle impose donc au courant électrique de contourner cette surface S.

Grâce à cette fente 110, le chemin de retour Ch', suivi par le courant électrique entre la première borne de sortie S1 et la première borne d'entrée E1, est donc proche du chemin Ch suivi à l'aller par le courant électrique de mode commun. On peut noter sur la figure 3 que le chemin de retour Ch' présente une forme particulière, qui a été déterminée par simulation numérique sur ordinateur.

Cette fente 110 permet ainsi de réduire l'aire de la boucle de courant électrique formée par le chemin aller Ch, et le chemin de retour Ch' du courant. Cela permet de réduire le couplage, par induction, entre cette boucle de courant et les pistes et conducteurs électriques situés en sortie du circuit électrique de filtrage, grâce à quoi les caractéristiques de filtre passe-bas du circuit sont préservées.

La fente 110 est située préférentiellement plus près des bornes de sortie que des bornes d'entrée du circuit.

La boucle de courant résiduelle, qui subsiste éventuellement malgré la fente, se trouve ainsi éloignée au maximum des bornes de sortie, et donc des pistes et conducteurs électriques situés en sortie du circuit électrique. Cet éloignement permet de réduire encore le couplage par induction mentionné ci-dessus.

Ici, la fente 110 s'étend plus précisément à l'aplomb de la surface S" délimitée par le deuxième créneau CR2, et la fente 110 ne se superpose à la piste 12 en aucun point de celle-ci. Ainsi, vu de dessus, la fente 110 s'étend dans la surface S", sans croiser la piste 12 (figure 2).

En plus de ne pas croiser la piste 12, la fente 110 est située de manière à ne pas être superposée dans son ensemble au chemin Ch suivi par la piste. Autrement formulé, l'axe de la fente, et le chemin Ch suivi par la piste 12, ne se superposent pas parallèlement l'un à l'autre. La demanderesse a en effet constaté qu'une superposition de la fente, parallèlement à une partie de la piste en question, augmenterait l'amplitude des perturbations électromagnétiques émises à hautes fréquences par le circuit.

La fente 110 est rectiligne. Elle s'étend parallèlement aux premier et deuxième bords 101, 102 de la plaque 10.

Elle débouche, d'un côté, sur un bord 103 de la couche conductrice 11, et présente, de l'autre côté, un bord d'extrémité 111.

La fente 110 s'étend sur plus des trois quarts de la largeur A de la couche conductrice 11.

Le bord d'extrémité 111 de la fente est donc situé à une distance d d'un bord 104 de la couche conductrice 11 qui est inférieure au quart de ladite largeur A.

La fente 110 génère ainsi un rétrécissement local de largeur de la couche conductrice 11.

Ici, la distance d est plus précisément inférieure à un dixième de la largeur A de la couche conductrice 11.

L'épaisseur e de la fente, qui correspond à la dimension de la fente perpendiculairement à son axe longitudinal, est ici comprise entre 0,5 millimètre et 10 millimètres.

Sans la fente, le chemin de retour correspondrait à la droite reliant la première borne de sortie S1 à la première borne d'entrée E1, et l'aire de la boucle de courant mentionnée plus haut serait donc sensiblement égale à l'aire de la surface S.

Comme le montrent les figures 2 et 3, en présence de la fente 110, l'aire de la boucle de courant correspond seulement à l'aire d'une partie de la surface S' délimitée par le premier créneau CR1.

On constate donc, pour cet exemple, que la fente 110 pratiquée dans la couche conductrice 11, entre la première borne de sortie S1 et la première borne d'entrée E1, permet effectivement de réduire le couplage par induction entre la boucle de courant précitée, et les pistes et conducteurs électriques situés en sortie du circuit électrique 1 de filtrage.

Plus précisément, la simulation numérique mentionnée ci-dessus montre que, pour cet exemple de réalisation, l'inductance mutuelle entre, d'une part, la boucle de courant délimitée par les chemin aller et retour, et, d'autre part, les pistes et conducteurs électriques situés en sortie du circuit électrique 1, est réduite d'un facteur 10 environ grâce à la fente 110.

Par ailleurs, le rétrécissement local de largeur de la couche conductrice 11, dû à la fente 110, permet d'augmenter l'inductance propre présentée par cette couche entre ses bornes d'entrée et de sortie E1 et S1, d'un facteur supérieur à 10 environ.

Augmenter cette inductance propre permet de réduire la fréquence d'une résonnance en courant présentée par le circuit électrique 1 et ses pistes de sortie (résonance due aux inductances et capacités propres des pistes et de la couche conductrice 11, et non aux composants électriques du circuit). Au voisinage de cette résonance, les performances du circuit en termes d'atténuation de composantes de courant électrique peuvent être dégradées. Réduire cette fréquence de résonance permet alors, à hautes fréquences, de conserver une atténuation élevée pour le circuit de filtrage.

Différentes variantes peuvent être apportées au circuit électrique qui a été décrit en détail plus haut.

Tout d'abord la piste qui relie la deuxième borne d'entrée à la deuxième borne de sortie pourrait suivre un chemin, non rectiligne, différent de celui représenté sur la figure 2, ou être positionnée différemment de ce qui a été représenté sur les figures.

Par ailleurs, pour imposer au courant électrique un chemin de retour proche du chemin aller, plusieurs fentes pourraient être pratiquées dans la couche conductrice.

D'autre part, la piste qui relie électriquement la deuxième borne d'entrée à la deuxième borne de sortie s'étend ici dans un même plan de connexion de la plaque de circuit imprimé multicouches. En variante, elle pourrait toutefois passer de l'un de ces plans de connexion à un autre. En particulier, les deuxièmes bornes d'entrée et de sortie pourraient être situées respectivement sur deux plans de connexion différents.

La plaque de circuit imprimée pourrait d'ailleurs comprendre un nombre de couches différent de quatre, par exemple deux couches (externes) seulement, situées respectivement sur les deux faces de la plaque.

D'autre part, le circuit électrique, configuré ici pour du courant électrique triphasé, pourrait bien sûr être simplifié pour filtrer un courant électrique monophasé (les troisième et quatrièmes bornes d'entrée et de sortie étant alors omises).

## Revendications

1. Circuit électrique (1) de filtrage pour un chargeur (3) de courant de véhicule automobile (5) électrique ou hybride, dont deux bornes de sortie sont destinées à être connectées à deux bornes de connexion dudit chargeur à un réseau d'électricité externe et dont deux bornes d'entrée sont destinées à être connectées à un dispositif de conversion d'énergie électrique dudit chargeur, ledit circuit électrique ayant une fonction de filtrage passe-bas des composantes de courant à hautes fréquences issues de la commutation des interrupteurs commandés dudit dispositif de conversion, ledit circuit électrique comprenant une plaque (10) de circuit imprimé qui supporte :
- une couche conductrice (11) s'étendant sur la majeure partie de l'aire de la plaque (10), et reliant électriquement une première borne d'entrée (E1) du circuit à une première borne de sortie (S1) du circuit,
- au moins un composant électrique (L2, L2', C2), et
- une piste (12) électrique pour la connexion dudit composant électrique (L2, L2', C2), qui s'étend dans un plan de connexion parallèle à celui de la couche conductrice (11), entre une deuxième borne d'entrée (E2) et une deuxième borne de sortie (S2) du circuit,
**caractérisé en ce que** la piste (12) s'étend le long d'un chemin (Ch) qui n'est pas rectiligne, et
**en ce qu'**une fente (110) est pratiquée dans la couche conductrice (11), la fente (110) étant située entre la première borne d'entrée (E1) et la première borne de sortie (S1), les première et deuxième borne d'entrée (E1, E2) étant disposées sur une première portion dudit circuit éloignée d'une deuxième portion dudit circuit où sont disposées les première et deuxième bornes de sortie (S1, S2).

2. Circuit électrique (1) selon la revendication 1, dans lequel la fente (110) est située à l'aplomb d'une surface (S, S") délimitée, dans le plan de connexion, par, d'une part, le chemin (Ch) suivi par ladite piste (12), et, d'autre part, la droite (D') reliant la deuxième borne d'entrée (E2) et la deuxième borne de sortie (S2).

3. Circuit électrique (1) selon la revendication 2, dans lequel le chemin (Ch) suivi par ladite piste (12) a une forme de créneau (CR1, CR2) comportant trois côtés adjacents.

4. Circuit électrique (1) selon l'une des revendications 1 à 3, dans lequel la fente (110) est située plus près de la deuxième borne de sortie (S2) que de la deuxième borne d'entrée (E2).

5. Circuit électrique (1) selon l'une des revendications 1 à 4, dans lequel la fente (110) n'est pas superposée dans son ensemble au chemin (Ch) suivi par la piste (12).

6. Circuit électrique (1) selon l'une des revendications 1 à 5, dans lequel la fente (110) ne se superpose en aucun point à ladite piste (12).

7. Circuit électrique (1) selon l'une des revendications 1 à 6, dans lequel la fente (110) débouche sur un bord (103) de la couche conductrice (11).

8. Circuit électrique (1) selon l'une des revendications 1 à 7, dans lequel, le fente (110) est rectiligne et présente une extrémité (111) située à une distance (d) d'un bord (104) de la couche conductrice (11) qui est inférieure au quart de la dimension (A) de cette couche selon l'axe de la fente.

9. Circuit électrique (1) selon l'une des revendications 1 à 8, dans lequel :
- la plaque (10) de circuit imprimé comprend en outre une troisième borne d'entrée (E3) et une troisième borne de sortie (S3) reliées l'une à l'autre par le circuit, ainsi qu'une quatrième borne d'entrée (E4) et une quatrième borne de sortie (S4) également reliées l'une à l'autre par le circuit, et dans lequel :
- le module d'une fonction de transfert du circuit électrique, égale :
- au courant électrique (i1) sortant du circuit par la première borne de sortie (S1), divisé par
- un courant électrique de mode commun (icmᵢₙ) qui est égal à la somme des courants électriques (i2ᵢₙ, i3ᵢₙ, i4ᵢₙ) entrant dans le circuit respectivement par la deuxième, la troisième et la quatrième bornes d'entrée (E2, E3, E4),
est inférieur à 1 pour les fréquences supérieures à une fréquence seuil donnée.

10. Chargeur (3) de courant pour véhicule automobile (5) électrique ou hybride, comprenant :
- au moins deux bornes de connexion (B1, B2) à un réseau de distribution (4) d'électricité externe,
- un dispositif de conversion (2) d'énergie électrique, configuré pour convertir une tension électrique alternative en une tension électrique continue, et
- un circuit électrique (1) de filtrage selon l'une des revendications 1 à 9, le circuit étant raccordé :
- au dispositif de conversion (2) par ses première et deuxième bornes d'entrée (E1, E2), et
- aux bornes de connexion (B1, B2) du chargeur (3) par ses première et deuxième bornes de sortie (S1, S2).

11. Véhicule automobile (5) électrique ou hybride comprenant un chargeur (3) de courant selon la revendication 10.

## Patentansprüche

1. Elektrische Filterungsschaltung (1) für ein Stromladegerät (3) eines Elektro- oder Hybridkraftfahrzeugs (5), von denen zwei Ausgangsklemmen dazu bestimmt sind, an zwei Klemmen zum Anschluss des Ladegeräts an ein externes Stromnetz angeschlossen zu sein, und von denen zwei Eingangsklemmen dazu bestimmt sind, an eine Vorrichtung zur Umwandlung elektrischer Energie des Ladegeräts angeschlossen zu sein, wobei die elektrische Schaltung eine Funktion zur Tiefpassfilterung der Hochfrequenzstromkomponenten aus der Umschaltung der gesteuerten Schalter der Umwandlungsvorrichtung aufweist, wobei die elektrische Schaltung eine Leiterplatte (10) umfasst, die Folgendes trägt:
- eine leitende Schicht (11), die sich auf dem größten Teil der Fläche der Platte (10) erstreckt und eine erste Eingangsklemme (E1) der Schaltung mit einer ersten Ausgangsklemme (S1) der Schaltung elektrisch verbindet,
- wenigstens ein elektrisches Bauelement (L2, L2', C2), und
- eine elektrische Leiterbahn (12) zum Anschluss des elektrischen Bauelements (L2, L2', C2), die sich in einer Anschlussebene, die parallel zur leitenden Schicht (11) verläuft, zwischen einer zweiten Eingangsklemme (E2) und einer zweiten Ausgangsklemme (S2) der Schaltung erstreckt, **dadurch gekennzeichnet, dass** sich die Bahn (12) einen Weg (Ch) entlang erstreckt, der nicht geradlinig ist, und dadurch, dass ein Spalt (110) in der leitenden Schicht (11) ausgebildet ist, wobei sich der Spalt (110) zwischen der ersten Eingangsklemme (E1) und der ersten Ausgangsklemme (S1) befindet, wobei die erste und zweite Eingangsklemme (E1, E2) auf einem ersten Teilbereich der Schaltung angeordnet sind, der von einem zweiten Teilbereich der Schaltung entfernt ist, wo die erste und zweite Ausgangsklemme (S1, S2) angeordnet sind.

2. Elektrische Schaltung (1) nach Anspruch 1, wobei sich der Spalt (110) lotrecht zu einer Fläche (S, S") befindet, die in der Anschlussebene einerseits von dem Weg (Ch), dem die Bahn (12) folgt, und andererseits der Geraden (D') begrenzt ist, die die zweite Eingangsklemme (E2) und die zweite Ausgangsklemme (S2) verbindet.

3. Elektrische Schaltung (1) nach Anspruch 2, wobei der Weg (Ch), dem die Bahn (12) folgt, eine Form einer Zinne (CR1, CR2) mit drei aneinander angrenzenden Seiten aufweist.

4. Elektrische Schaltung (1) nach einem der Ansprüche 1 bis 3, wobei sich der Spalt (110) näher an der zweiten Ausgangsklemme (S2) als an der zweiten Eingangsklemme (E2) befindet.

5. Elektrische Schaltung (1) nach einem der Ansprüche 1 bis 4, wobei der Spalt (110) nicht als Ganzes dem Weg (Ch) überlagert ist, dem die Bahn (12) folgt.

6. Elektrische Schaltung (1) nach einem der Ansprüche 1 bis 5, wobei der Spalt (110) an keinem Punkt die Bahn (12) überlagert.

7. Elektrische Schaltung (1) nach einem der Ansprüche 1 bis 6, wobei der Spalt (110) an einem Rand (103) der leitenden Schicht (11) mündet.

8. Elektrische Schaltung (1) nach einem der Ansprüche 1 bis 7, wobei der Spalt (110) geradlinig ist und ein Ende (111) aufweist, das sich in einem Abstand (d) von einem Rand (104) der leitenden Schicht (11) befindet, der kleiner als ein Viertel der Abmessung (A) dieser Schicht entlang der Achse des Spalts ist.

9. Elektrische Schaltung (1) nach einem der Ansprüche 1 bis 8, wobei:
- die Leiterplatte (10) ferner eine dritte Eingangsklemme (E3) und eine dritte Ausgangsklemme (S3), die durch die Schaltung miteinander verbunden sind, sowie eine vierte Eingangsklemme (E4) und eine vierte Ausgangsklemme (S4), die ebenfalls durch die Schaltung miteinander verbunden sind, umfasst, und wobei:
- der Modul einer Übertragungsfunktion der elektrischen Schaltung, gleich:
- dem elektrischen Strom (¡1), der die Schaltung durch die erste Ausgangsklemme (S1) verlässt, geteilt durch
- einen elektrischen Gleichtaktstrom (icmᵢₙ), der gleich der Summe der elektrischen Ströme (i2ᵢₙ, i3ᵢₙ, i4ᵢₙ) ist, die durch die zweite, die dritte bzw. vierte Eingangsklemme (E2, E3, E4) in die Schaltung gelangen, für die Frequenzen, die größer als eine bestimmte Schwellenfrequenz sind, kleiner als 1 ist.

10. Stromladegerät (3) für ein Elektro- oder Hybridkraftfahrzeug (5), umfassend:
- wenigstens zwei Klemmen zum Anschluss (B1, B2) an ein externes Stromverteilungsnetz (4),
- eine Vorrichtung zur Umwandlung (2) elektrischer Energie, die dazu ausgebildet ist, eine elektrische Wechselspannung in eine elektrische Gleichspannung umzuwandeln, und
- eine elektrische Filterungsschaltung (1) nach einem der Ansprüche 1 bis 9, wobei die Schaltung an Folgendes angeschlossen ist:
- an die Umwandlungsvorrichtung (2) über ihre erste und zweite Eingangsklemme (E1, E2), und
- an die Anschlussklemmen (B1, B2) des Ladegeräts (3) über ihre erste und zweite Ausgangsklemme (S1, S2).

11. Elektro- oder Hybridkraftfahrzeug (5), umfassend ein Stromladegerät (3) nach Anspruch 10.

## Claims

1. Electrical filter circuit (1) for a current charger (3) of an electric or hybrid motor vehicle (5), two output terminals of which are intended to be connected to two terminals for connecting said charger to an external electricity network and two input terminals of which are intended to be connected to an electric power converter device of said charger, said electrical circuit having a function of low-pass filtering of the high-frequency current components originating from the switching of the controlled switches of said converter device, said electrical circuit comprising a printed circuit board (10) which bears:
- a conductive layer (11) extending over most of the area of the board (10), and electrically connecting a first input terminal (E1) of the circuit to a first output terminal (S1) of the circuit,
- at least one electrical component (L2, L2', C2), and
- an electrical trace (12) for connecting said electrical component (L2, L2', C2), which extends in a connection plane which is parallel to that of the conductive layer (11), between a second input terminal (E2) and a second output terminal (S2) of the circuit,
**characterized in that** the trace (12) extends along a path (Ch) which is not rectilinear, and
**in that** a slot (110) is made in the conductive layer (11), the slot (110) being located between the first input terminal (E1) and the first output terminal (S1), the first and second input terminals (E1, E2) being arranged on a first portion of said circuit which is distant from a second portion of said circuit where the first and second output terminals (S1, S2) are arranged.

2. Electrical circuit (1) according to Claim 1, in which the slot (110) is located flush with a surface (S, S") delimited, in the connection plane, by, on the one hand, the path (Ch) followed by said trace (12), and, on the other hand, the straight line (D') connecting the second input terminal (E2) and the second output terminal (S2) .

3. Electrical circuit (1) according to Claim 2, in which the path (Ch) followed by said trace (12) is in the shape of a crenelation (CR1, CR2) comprising three adjacent sides.

4. Electrical circuit (1) according to one of Claims 1 to 3, in which the slot (110) is located closer to the second output terminal (S2) than to the second input terminal (E2).

5. Electrical circuit (1) according to one of Claims 1 to 4, in which the slot (110) is not superposed in its entirety on the path (Ch) followed by the trace (12).

6. Electrical circuit (1) according to one of Claims 1 to 5, in which the slot (110) is not superposed at any point on said trace (12).

7. Electrical circuit (1) according to one of Claims 1 to 6, in which the slot (110) opens onto an edge (103) of the conductive layer (11).

8. Electrical circuit (1) according to one of Claims 1 to 7, in which the slot (110) is rectilinear and has an end (111) located at a distance (d) from an edge (104) of the conductive layer (11) which is less than a quarter of the size (A) of this layer along the axis of the slot.

9. Electrical circuit (1) according to one of Claims 1 to 8, in which:
- the printed circuit board (10) further comprises a third input terminal (E3) and a third output terminal (S3) connected to one another by the circuit, as well as a fourth input terminal (E4) and a fourth output terminal (S4) also connected to one another by the circuit, and in which:
- the modulus of a transfer function of the electrical circuit, which is equal:
- to the electric current (i1) leaving the circuit by the first output terminal (S1), divided by
- a common-mode electric current (icmᵢₙ), which is equal to the sum of the electric currents (i2ᵢₙ, i3ᵢₙ, i4ᵢₙ) entering the circuit respectively by the second, the third and the fourth input terminals (E2, E3, E4), is less than 1 for frequencies greater than a given threshold frequency.

10. Current charger (3) for an electric or hybrid motor vehicle (5), comprising:
- at least two terminals (B1, B2) for connecting to an external electricity distribution network (4),
- an electric power converter device (2), configured to convert an AC voltage into a DC voltage, and
- an electrical filter circuit (1) according to one of Claims 1 to 9, the circuit being connected:
- to the converter device (2) by its first and second input terminals (E1, E2), and
- to the connection terminals (B1, B2) of the charger (3) by its first and second output terminals (S1, S2) .

11. Electric or hybrid motor vehicle (5), comprising a current charger (3) according to Claim 10.
